# FASCICULE DE BREVET EUROPEEN

(11) **EP 3 664 234 B1**
(45) Date de publication et mention de la délivrance du brevet: **26.03.2025**
(21) Numéro de dépôt: 19207764.2
(22) Date de dépôt: 07.11.2019
(51) Int. Cl.: H02B 1/28, H02B 1/56, H05K 7/20, F04D 29/42, F04D 25/14, F04D 29/44, F04D 29/46, F04D 29/70

(54) **BLOC DE VENTILATION POUR ARMOIRE ELECTRIQUE**
BELÜFTUNGSBLOCK FÜR ELEKTRISCHEN SCHALTSCHRANK
VENTILATION UNIT FOR AN ELECTRICAL CABINET

(30) Priorité: 07.12.2018 FR 1872476
(43) Date de publication de la demande: 10.06.2020
(73) Titulaire: Schneider Electric Industries SAS, 92500 Rueil Malmaison (FR)
(72) Inventeur: LINARES, Louis, 38050 Grenoble Cedex 09 (FR); LOPEZ, Josep, 38050 Grenoble Cedex 09 (FR)
(74) Mandataire: Lavoix

(56) Documents cités:
- EP-A1- 1 878 484
- WO-A1-2014/035661
- WO-A1-2015/127989
- DE-A1- 3 013 756
- DE-U1- 202013 103 846
- DE-U1- 9 408 362
- US-A1- 2013 067 875
- US-A1- 2013 314 850

## Description

La présente invention se rapporte à un bloc de ventilation pour enveloppe électrique telle que par exemple une armoire électrique.

L'invention concerne également une installation électrique comprenant une enveloppe électrique sur laquelle sont positionnés plusieurs blocs de ventilation conformes à l'invention.

### Etat de la technique

La gestion de la température dans l'enceinte d'une enveloppe électrique, telle qu'une armoire électrique ou un coffret électrique, est une question traitée de manière récurrente. Les appareils présents dans l'armoire électrique ont tendance à chauffer et il est donc nécessaire de maintenir la température à l'intérieur de l'armoire sous un certain seuil, au risque sinon de dégrader les appareils. Pour répondre à cette contrainte, il est classique d'utiliser un système de ventilation pour créer un flux d'air à travers le volume de l'armoire électrique en aspirant de l'air présent à l'extérieur et en évacuant l'air chaud présent dans l'armoire vers l'extérieur.

Les systèmes de ventilation connus sont couramment placés sur la paroi supérieure de l'armoire électrique. Ils comprennent une entrée reliée au volume interne de l'armoire pour recevoir un flux d'air sortant, une sortie d'air et un ventilateur placé entre l'entrée et la sortie pour entraîner le flux d'air de l'entrée vers la sortie.

En général, le système de ventilation associé à une armoire électrique est formé d'un bloc positionné sur la paroi supérieure de l'armoire électrique. Ce bloc est le plus souvent conçu pour répondre à un seul indice de protection (IP) uniquement, limitant son usage. De plus il est très souvent imposant et occupe toute la paroi supérieure de l'armoire, ce qui n'offre aucune possibilité pour adapter facilement le flux d'air à générer à travers l'armoire électrique, par exemple en cas d'évolution de l'appareillage électrique logé dans l'armoire électrique, ni aucune possibilité de redondance entre plusieurs blocs de ventilation associés à une même armoire électrique.

WO 2014/035661 A1 divulgue ainsi un bloc de ventilation comprenant un ventilateur et un boitier en forme de pavé droit. Un socle du boitier est fermé vers le haut par un couvercle et est traversé à sa base par une ouverture autour de laquelle un siège accueille le ventilateur. WO 2014/035661 A1 envisage que, sur chaque face latérale de son boitier, le socle comporte une grille autorisant la circulation d'air à travers elle.

EP 1 878 484 A1 divulgue un bloc de ventilation comprenant un ventilateur et un boitier incluant une seule grille latérale, sur la face extérieure de laquelle est rapporté un filtre interchangeable. Le filtre est maintenu en place contre la grille par une grille qui, par pivotement, donne accès au filtre pour le changer, sans avoir besoin d'utiliser un outil.

WO 2015/127989 A1 divulgue un appareil électroménager, tel qu'un lave-linge, un lave-vaisselle, un réfrigérateur. L'intérieur de cet appareil électroménager est mis en communication avec l'extérieur au travers d'un dispositif de grille à travers lequel l'air est entrainé par un ventilateur agencé à l'intérieur de l'appareil électroménager. Le dispositif de grille comporte deux grilles qui sont reliées l'une à l'autre par une charnière d'articulation. En service, les deux grilles sont rabattues et maintenues à demeure l'une contre l'autre. Préalablement à leur mise en service, les deux grilles sont fabriquées par moulage dans un état non fonctionnel du dispositif de grille, où ces deux grilles sont juxtaposées bord à bord dans un même plan géométrique.

Le but de l'invention est de proposer un bloc de ventilation destiné à être utilisé pour une enveloppe électrique, qui puisse notamment proposer plusieurs indices de protection sans avoir à être remplacé et sans modification complexe de son architecture. Le bloc de ventilation pourra facilement être associé à un ou plusieurs autres blocs de ventilation similaires pour remplir les objectifs définis ci-dessus.

### Exposé de l'invention

Ce but est atteint par un bloc de ventilation pour enveloppe électrique, tel que défini à la revendication 1.

Des particularité de ce bloc de ventilation sont spécifiées aux revendications 2 à 7.

L'invention concerne également une installation électrique telle que définie à la revendication 8.

Des particularités de cette installation sont spécifiées aux revendications 9 et 10.

### Brève description des figures

D'autres caractéristiques et avantages vont apparaître dans la description détaillée qui suit faite en regard des dessins annexés dans lesquels :
[Fig.1] La figure 1 représente un bloc de ventilation conforme à l'invention.
[Fig.2] La figure 2 représente le bloc de ventilation conforme à l'invention, en vue éclatée.
[Fig.3]
[Fig.4]
[Fig.5]

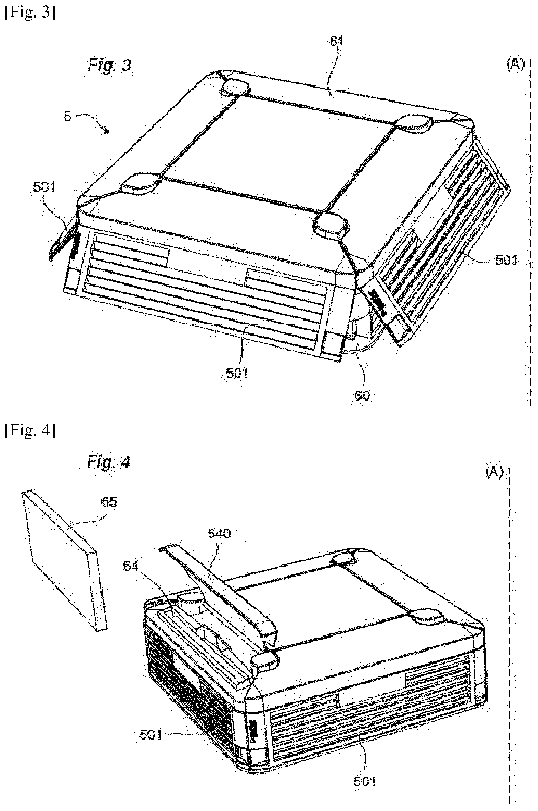

Les figures 3, 4 et 5 représentent différentes configurations du bloc de ventilation conforme à l'invention.
[Fig.6A]
[Fig.6B]
[Fig.6C]
[Fig.6D]
[Fig.6E]

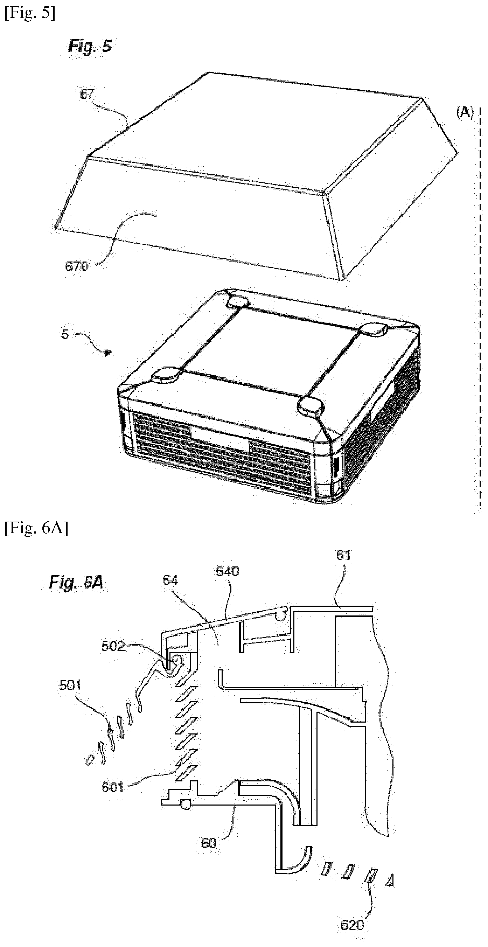

Les figures 6A à 6E illustrent, par des vues en coupe, différentes configurations prises par le bloc de ventilation de l'invention.
[Fig.7]
[Fig.8]
[Fig.9]
[Fig.10]

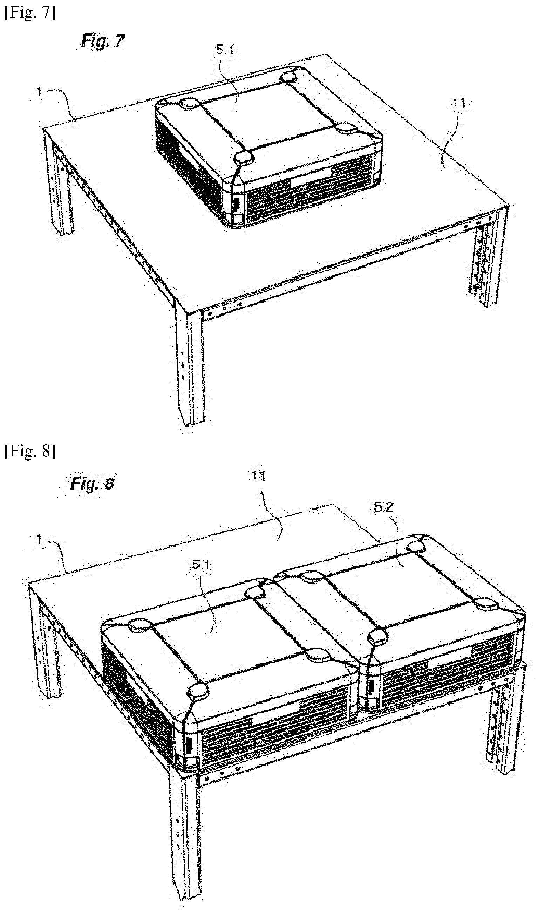

Les figures 7 à 10 illustrent le principe de juxtaposition de plusieurs blocs de ventilation conforme à l'invention.

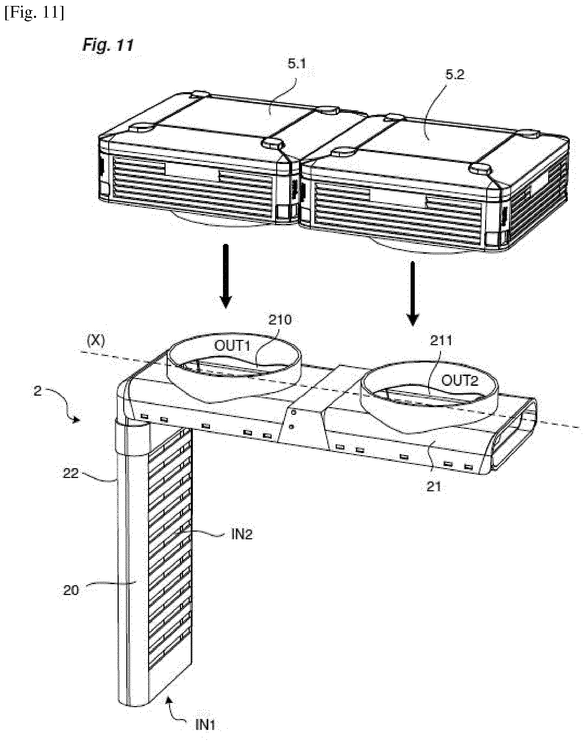

[Fig.11] La figure 11 représente un système de gestion de flux d'air employé en association avec deux blocs de ventilation conformes à l'invention.
[Fig.12A]
[Fig.12B]

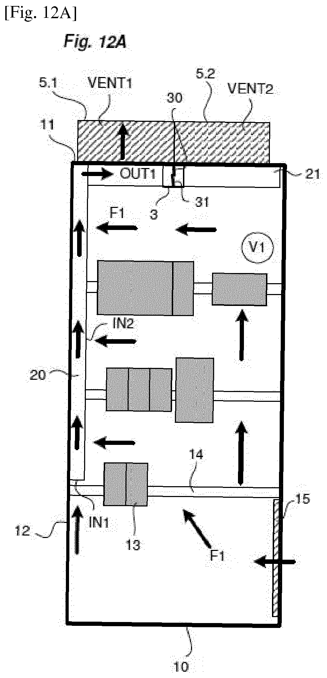

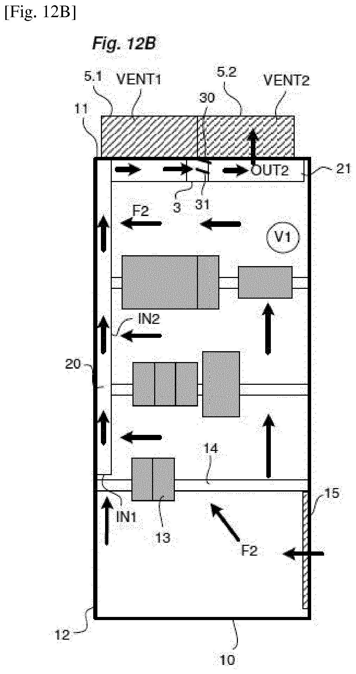

Les figures 12A et 12B illustrent le principe de fonctionnement du système de gestion de flux d'air conforme à l'invention.

### Description détaillée d'au moins un mode de réalisation

L'invention concerne un système de ventilation qui est adaptable sur une enveloppe électrique. Par enveloppe électrique, on entend une armoire électrique, un coffret électrique ou équivalent. Dans la suite de la description et sur les dessins, on considérera que l'enveloppe électrique est une armoire électrique 1.

Dans la suite de la description, les termes "supérieur", "inférieur" ou équivalents sont à prendre en compte en fonction d'un axe (A) vertical représenté sur les figures annexées.

De manière non limitative, une armoire électrique 1 peut comporter une paroi inférieure 10, une paroi supérieure 11 et quatre parois latérales 12 opposées deux à deux. Ses parois délimitent un premier volume interne V1 dans lequel sont placés des appareils électriques. Dans l'armoire électrique, les appareils électriques 13 peuvent être montés sur des supports, tels que montants et rails 14 adaptés. L'armoire électrique 1 comporte une grille 15 permettant à son volume interne d'échanger de l'air avec l'extérieur. Les figures 12A et 12B permettent de bien montrer les caractéristiques d'une telle armoire électrique.

L'armoire électrique 1 pourra être fabriquée dans un matériau métallique.

Le système de ventilation comporte un ou plusieurs blocs de ventilation 5 (également référencé 5.1, 5.2, 5.3, 5.4 sur les figures annexées lorsque plusieurs blocs sont présents), chaque bloc de ventilation 5 étant placé sur la paroi supérieure 11 de l'armoire électrique 1 et comporte une entrée d'air en communication avec le volume interne V1 de l'armoire électrique Classiquement, en fonctionnement, chaque bloc de ventilation 5 crée un flux d'air à travers le volume de l'armoire 1, en prélevant de l'air à l'extérieur à travers la grille 15 et en rejetant l'air chaud vers l'extérieur. La grille 15 est avantageusement placée en bas de l'armoire électrique, à l'opposé de chaque bloc de ventilation, pour permettre au flux d'air de circuler dans tout le volume interne V1 de l'armoire électrique (voir figures 12A et 12B).

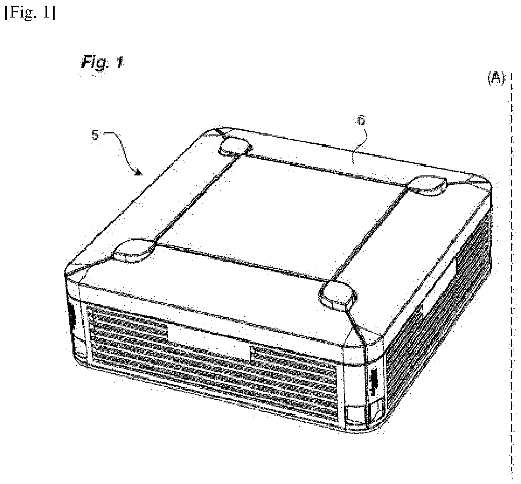

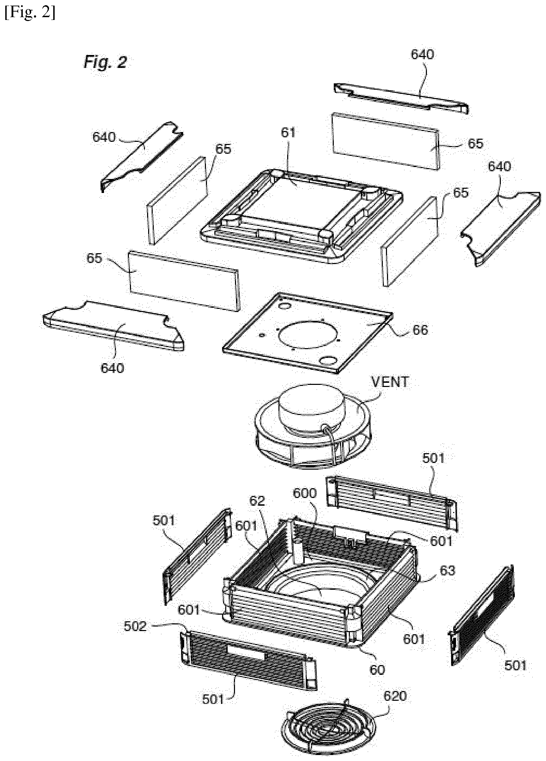

En référence aux figures 1 et 2, un bloc de ventilation 5 conforme à l'invention comporte un boîtier 6 comprenant principalement un socle 60 et un couvercle 61 assemblé sur ledit socle et un ventilateur VENT venant se loger dans ledit boîtier 6.

Le bloc de ventilation 5 présente une forme de pavé droit à base carrée, ce qui, on le verra ci-après, lui permet de facilement s'associer à d'autres blocs de ventilation identiques, dans un encombrement limité. Le bloc de ventilation 5 présente ainsi une face supérieure, une face inférieure et quatre faces latérales parallèles deux à deux.

Son socle 60 comporte une paroi inférieure 600 dont la face externe forme la face inférieure du bloc 5 et plusieurs flancs latéraux, réalisés suivant les quatre faces latérales du bloc de ventilation.

La paroi inférieure du socle 60 comporte une ouverture 62, par exemple de forme circulaire et autour de cette ouverture, un siège 63 pour y assembler le ventilateur VENT du bloc de ventilation 5. Des moyens de fixation du ventilateur peuvent être prévus sur ledit siège 63 pour assurer la fixation du ventilateur dans son logement. Le ventilateur VENT est positionné sur le siège 63 pour faire coïncider son entrée d'air avec l'ouverture 62. Une grille 620 de forme circulaire peut être placée devant son ouverture 62.

La paroi latérale du socle 60 est réalisée sous la forme de quatre grilles, dites grilles internes 601, réalisées suivant les quatre faces du bloc de ventilation 5.

Le couvercle 61 est destiné à venir s'assembler sur le socle 60 pour venir le refermer par le dessus. Il se présente sous la forme d'une plaque dont la face externe forme la face supérieure du bloc de ventilation.

Le bloc 5 comporte également quatre grilles mobiles, dites grilles externes 501, destinées chacune à venir se placer devant une grille interne 601 du socle pour pouvoir se positionner suivant une face latérale distincte du bloc. Chacune de ces grilles externes 501 mobiles est montée en pivotement autour d'un axe qui suit l'arête supérieure de la face latérale du bloc 5. Chaque grille externe 501 mobile peut être fixée au couvercle et peut comporter deux pattes de fixation 502 opposées montées chacune en pivotement dans un orifice du couvercle 61. Chaque grille externe 501 mobile peut ainsi prendre une position dite fermée dans laquelle elle est repliée contre la grille interne 601 correspondante du socle et une ou plusieurs autres positions ouvertes dans chacune desquelles elle peut être pivotée autour de son axe suivant un angle d'inclinaison particulier, non nul.

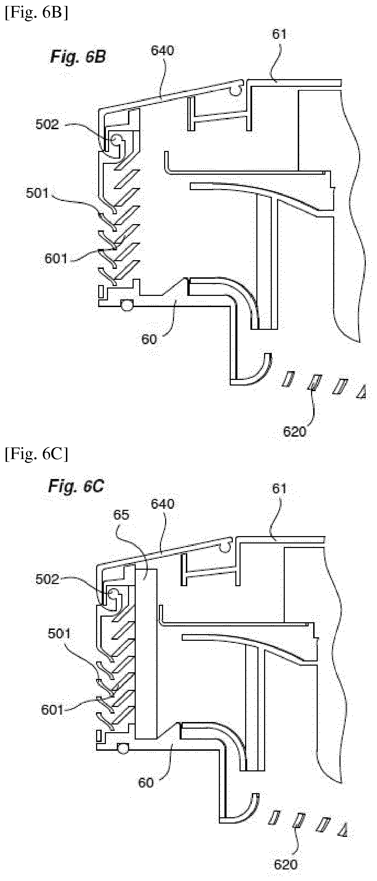

Les grilles internes 601 et les grilles externes 501 présentent chacune des ailettes. Les ailettes de chaque grille interne 601 sont inclinées d'un angle aigu par rapport à un plan vertical et les ailettes de chaque grille externe 501 correspondante sont inclinées de manière symétrique par rapport audit plan vertical (formant alors des chevrons) (voir figure 6B).

Le long de chacun de ses bords externes, le couvercle 61 peut aussi comporter une fente 64 distincte qui débouche dans un logement interne du boîtier 6. Ce logement est situé juste devant la grille interne 601 correspondante du socle et est agencé pour accueillir un élément de filtration 65. Pour chaque fente 64, le couvercle peut comporter un clapet pivotant 640 destiné à recouvrir la fente en position fermée et à permettre l'accès à la fente 64 et au logement en position ouverte après pivotement.

L'élément de filtration 65 peut être tout élément de type mousse ou équivalent permettant de retenir des particules et de laisser passer un flux d'air.

Le bloc de ventilation 5 peut également comporter une plaque 66 agencée entre la tête du ventilateur et le couvercle, destinée au maintien du ventilateur dans le bloc de ventilation.

Par ailleurs, le bloc de ventilation 5 peut également comporter un capot de protection 67 (figure 5), ajouté pour renforcer son indice de protection (IP). Ce capot de protection 67 prend la forme d'un chapeau et comporte une plaque supérieure de forme carrée destinée à venir reposer sur le couvercle et plusieurs flancs inclinés 670 vers le bas et vers l'extérieur, destinés chacun à se positionner devant une face latérale distincte du bloc pour la protéger.

Selon une particularité, le bloc de ventilation 5 conforme à l'invention présente ainsi une architecture qui lui permet de proposer différents indices de protection, simplement en changeant sa configuration. Les figures 6A à 6E illustrent ainsi les différentes configurations du bloc de ventilation, pour chaque indice de protection.

Figure 6A - IP41 : Pour être dans cette première configuration, le bloc n'intègre pas les éléments de filtration et chaque grille externe 501 est pivotée d'un angle déterminé non nul et avantageusement inférieur à 90°.

Figure 6B - IP44 : Cette deuxième configuration est identique à la première configuration, à l'exception du fait que les grilles externes 501 sont toutes repliées et qu'elles sont donc positionnées devant chaque grille interne 601.

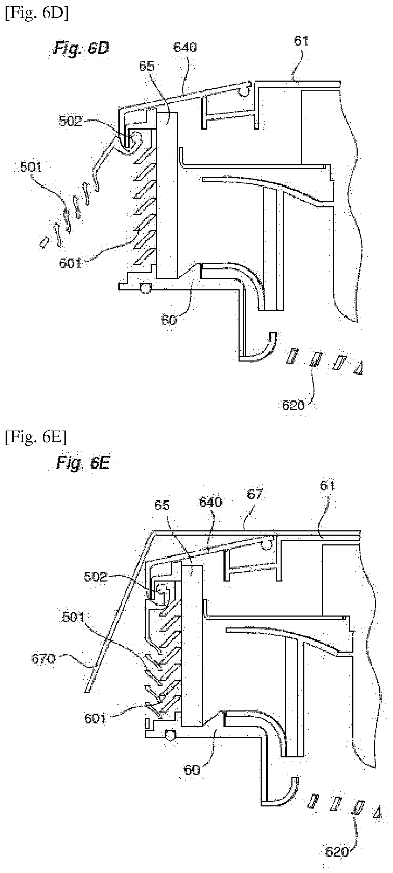

Figure 6D - IP54 : Cette troisième configuration reprend les caractéristiques de la première configuration, en y ajoutant un élément de filtration 65 devant chaque grille interne 601. Dans cette configuration, les grilles externes 501 sont donc chacune pivotées d'un angle déterminé non nul.

Figure 6C - IP55 : Cette quatrième configuration est identique à la troisième configuration, à l'exception du fait que les grilles externes 501 sont repliées contre les grilles internes 601.

Figure 6E - IP55 "extérieur" : Cette cinquième configuration est identique la quatrième configuration, le bloc de ventilation comprenant en plus son capot de protection 67 venant recouvrir son boîtier.

Par ailleurs, il faut noter que chacune de ces cinq configurations permet également de régler le débit d'air. Le débit pourra en effet être maximal dans la première configuration. Il sera plus faible dans la deuxième configuration, car freiné par les grilles externes 501 et encore plus faible dans la troisième configuration par l'ajout des éléments de filtration.

Comme évoqué précédemment, la forme carrée du bloc de ventilation 5 lui permet de facilement être associé à un ou plusieurs autres blocs de ventilation identiques, en optimisant l'espace occupé.

Selon une particularité de l'invention, il est en effet possible de juxtaposer au moins deux blocs de ventilation conformes à l'invention sur la paroi supérieure de l'armoire. Les deux blocs 5.1, 5.2 sont associés de manière jointive, de sorte qu'une face latérale de l'un est en appui contre une face latérale de l'autre.

La figure 7 illustre tout d'abord une solution à un seul bloc de ventilation 5.1. Celui-ci peut par exemple être placé au centre sur la paroi supérieure de l'armoire électrique.

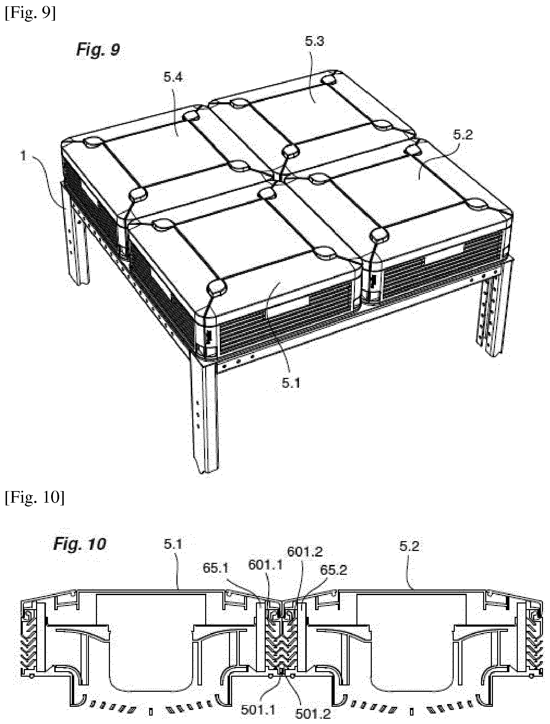

La figure 8 illustre ensuite une solution à deux blocs de ventilation 5.1, 5.2 juxtaposés, placés la paroi supérieure 11 de l'armoire électrique 1. Dans cette solution, comme visible sur la figure 10, pour réaliser une juxtaposition jointive, les grilles externes 501.1, 501.2 adossées l'une contre l'autre sont forcément repliées contre leur grille interne 601.1, 601.2 respective. On peut noter que les grilles externes des faces non jointives pourraient pour leur part être relevées selon la configuration IP choisie. Dans cette configuration, l'accolement parfait des deux blocs de ventilation 5.1, 5.2 permet d'éviter tout reflux d'air dans cette zone et donc toute perte de rendement du système à deux blocs. Sur la figure 10, les éléments de filtration 65.1, 65.2 sont présents mais restent optionnels.

La figure 9 représente une solution à quatre blocs de ventilation 5.1, 5.2, 5.3, 5.4 juxtaposés, placés sur la paroi supérieure de l'armoire électrique. Les quatre blocs forment ainsi un grand carré. Dans cette solution, chaque bloc de ventilation présente ainsi deux de ses faces latérales qui sont jointives avec une face latérale d'un bloc de ventilation adjacent. Comme précédemment, les jonctions sont réalisées de manière à éviter tout reflux d'air et n'occasionne donc pas de perte de rendement. Les grilles externes des faces non jointives peuvent être relevées pour répondre à un indice de protection particulier.

En cas d'implantation à l'extérieur (version "outdoor"), Il est également possible de prévoir un capot de forme adaptée, venant recouvrir deux, trois ou quatre blocs de ventilation juxtaposés.

La possibilité de disposer plusieurs blocs de ventilation 5.1, 5.2, 5.3, 5.4 conformes à l'invention sur une même paroi supérieure 11 d'une armoire électrique 1 permet d'ajuster aisément le débit d'air nécessaire au refroidissement des appareils électriques 13 présents dans l'armoire électrique 1. Il est notamment possible d'augmenter ou de diminuer le nombre de blocs de ventilation installés sur l'armoire en fonction du besoin.

Selon un aspect particulier de l'invention, illustré par la figure 11, il est également possible de prévoir deux blocs de ventilation 5.1, 5.2 conformes à l'invention, utilisés en redondance grâce à l'adjonction d'un système 2 de gestion de flux d'air adapté dans l'installation électrique globale. Ce système 2 de gestion de flux d'air peut comporter un boîtier 22 se présentant sous la forme de deux goulottes 20, 21 connectées entre elles en angle droit et placées avantageusement à l'intérieur du volume de l'armoire électrique 1. La première goulotte 20 peut comporter plusieurs entrées d'air IN1, IN2 par lesquelles pénètre le flux d'air généré dans l'armoire électrique. La deuxième goulotte 21 s'étend suivant un axe (X) et comporte pour sa part deux ouvertures 210, 211 formant chacune une sortie d'air OUT1, OUT2 distincte mise en communication avec un bloc de ventilation distinct. Ce système comporte en outre un dispositif d'aiguillage du flux d'air 3 composé par exemple de deux volets mobiles 30, 31 en pivotement. Les deux volets mobiles 30, 31 sont aptes à prendre une première position, dite fermée, dans laquelle ils obturent la liaison entre chaque entrée d'air IN1, IN2 et la deuxième sortie d'air OUT2 et une deuxième position dite ouverte, dans laquelle ils autorisent la liaison entre chaque entrée d'air IN1, IN2 et la deuxième sortie d'air OUT2. De manière avantageuse, les deux volets mobiles 30, 31 peuvent être commandés et aptes à pivoter par la seule pression du flux d'air circulant dans la deuxième goulotte du système.

On peut également noter que le système se trouve placé dans le volume V1 de l'armoire électrique alors que les deux blocs de ventilation 5.1, 5.2 sont à l'extérieur de l'armoire électrique.

En référence aux figures 12A et 12B, le principe de fonctionnement en redondance des deux blocs de ventilation 5.1, 5.2 est le suivant :
- Dans un premier état de fonctionnement de ce système (figure 12A), le ventilateur VENT1 du premier bloc de ventilation 5.1 est en fonctionnement et le ventilateur VENT2 du deuxième bloc de ventilation 5.2 est arrêté. Le flux d'air F1 prélevé à l'intérieur de l'armoire électrique 1, pénètre dans le système par chaque entrée d'air IN1, IN2, passe dans la première goulotte 20 pour rejoindre la deuxième goulotte 21. Le ventilateur VENT1 étant en fonctionnement, le flux d'air F1 est entraîné vers la première sortie d'air OUT1 du système 2 et s'échappe vers l'extérieur via la première sortie d'air OUT1 et le ventilateur VENT1. Le ventilateur VENT2 étant à l'arrêt, aucun flux d'air ne vient pousser les volets mobiles 30, 31, ceux-ci restant alors dans leur position fermée.
- Dans un deuxième état de fonctionnement de ce système (figure 12B), le ventilateur VENT1 du premier bloc de ventilation 5.1 est à l'arrêt (il est par exemple en panne ou en maintenance...). Le ventilateur VENT2 du deuxième bloc de ventilation 5.2 est activé. Le flux d'air F2 prélevé dans le volume V1 de l'armoire électrique 1, pénètre dans le système 2 par chaque entrée d'air IN1, IN2, passe dans la première goulotte 20 pour rejoindre la deuxième goulotte 21. Le ventilateur VENT1 étant à l'arrêt et le ventilateur VENT2 en fonctionnement, le flux d'air F2 se dirige vers la deuxième sortie d'air OUT2. Le flux d'air F2 applique une pression sur les volets mobiles 30, 31 et les pousse pour les faire pivoter. Le flux d'air F2 traverse ainsi l'ouverture créée grâce au pivotement des volets et gagne la deuxième sortie d'air OUT2 pour être évacué vers l'extérieur grâce au ventilateur VENT2.

On peut noter que la détection de l'arrêt du ventilateur VENT1 et l'activation du ventilateur VENT2 peuvent être effectués par tous moyens, de type automatiques et/ou manuels.

La solution de l'invention présente ainsi de nombreux avantages, parmi lesquels :
- Une solution de bloc de ventilation 5 fiable qui permet de proposer, à partir d'une même architecture, plusieurs indices de protection différents ;
- Un bloc de ventilation 5 facile à implanter et à associer à un ou plusieurs autres blocs de ventilation identiques, permettant d'offrir une grande modularité et une solution adaptable au besoin ;
- Un bloc de ventilation 5 ayant une architecture simple, tout en étant particulièrement efficace.

## Revendications

1. Bloc de ventilation (5) pour enveloppe électrique,
comprenant un ventilateur (VENT) et un boîtier (6) qui comporte un socle (60) et un couvercle (61) assemblé sur le socle,
dans lequel le boîtier (6) présente une forme de pavé droit ayant une base carrée, quatre faces latérales et une face supérieure,
dans lequel ledit socle (60) comporte une paroi inférieure (600) formant ladite base du boîtier et une paroi latérale suivant les quatre faces latérales du boîtier, une ouverture (62) réalisée à travers sa paroi inférieure et un siège réalisé autour de son ouverture et accueillant le ventilateur,
dans lequel le couvercle (61) est apposé sur le socle (60) et comporte la face supérieure du boîtier,
et dans lequel, suivant chaque face latérale, la paroi latérale du socle comporte une première grille (601),
**caractérisé en ce que**, suivant chaque face latérale, le bloc de ventilation (5) comporte une deuxième grille (501) montée en pivotement entre :
- une position fermée, dans laquelle la deuxième grille (501) recouvre la première grille (601) de la face latérale correspondante, en étant repliée contre cette première grille, de manière que le bloc de ventilation (5) présente une première configuration définissant un premier indice de protection (IP) du bloc de ventilation, et
- une ou plusieurs positions ouvertes, dans chacune desquelles la deuxième grille (501) est relevée par rapport à la première grille (601) de la face latérale correspondante, en étant pivotée suivant un angle d'inclinaison déterminé qui est non nul, de manière que le bloc de ventilation (5) présente une configuration qui est différente de la première configuration et qui définit un indice de protection (IP) du bloc de ventilation, différent du premier indice de protection.

2. Bloc de ventilation selon la revendication 1, **caractérisé en ce qu'**il comporte plusieurs logements internes du boîtier (6), qui sont agencés chacun devant chaque première grille du socle et **en ce que** le bloc de ventilation comporte un élément de filtration (65) distinct positionné dans chaque logement, devant chaque première grille du socle.

3. Bloc de ventilation selon la revendication 2, **caractérisé en ce que** le couvercle comporte plusieurs clapets pivotants (640), donnant chacun accès à un logement distinct accueillant l'élément de filtration (65).

4. Bloc de ventilation selon l'une des revendications 1 à 3, **caractérisé en ce que** chaque deuxième grille (501) est fixée sur le couvercle (61) et montée en pivotement sur ledit couvercle.

5. Bloc de ventilation selon l'une des revendications 1 à 4, **caractérisé en ce qu'**il comporte un capot de protection (67) formant un chapeau destiné à recouvrir ledit boîtier (6).

6. Bloc de ventilation selon la revendication 5, **caractérisé en ce que** le capot de protection (67) comporte une paroi principale apposé sur le couvercle et plusieurs flancs latéraux inclinés s'étendant devant les faces latérales dudit boîtier (6).

7. Bloc de ventilation selon l'une des revendications 1 à 6, **caractérisé en ce que**, dans la ou chaque position ouverte, l'angle d'inclinaison est inférieur à 90°.

8. Installation électrique comprenant une enveloppe électrique dotée d'une paroi inférieure (10), d'une paroi supérieure (11) et de parois latérales (12), **caractérisé en ce qu'**elle comporte un système de ventilation modulaire comprenant plusieurs blocs de ventilation (5.1, 5.2, 5.3, 5.4) indépendants identiques, chaque bloc de ventilation étant tel que défini dans l'une des revendications 1 à 7 et positionné sur la paroi supérieure (11) de l'enveloppe électrique.

9. Installation électrique selon la revendication 8, **caractérisé en ce que** les blocs de ventilation sont positionnés sur la paroi supérieure (11) de l'armoire électrique de manière jointive par au moins une de leur face latérale au niveau de laquelle les deuxième grilles respectives (501) des blocs de ventilation sont chacune dans leur position fermée.

10. Installation électrique selon la revendication 8 ou 9, **caractérisée en ce qu'**elle comporte un système de gestion de flux d'air adaptable sur l'enveloppe électrique, ledit système de gestion de flux d'air comportant :
- Un boîtier (22) comprenant au moins une entrée d'air (IN1, IN2) destinée à être mise en communication avec le volume interne (V1) de l'enveloppe électrique, au moins deux sorties d'air (OUT1, OUT2) et au moins une goulotte principale (20) agencée pour relier ladite entrée d'air (IN) aux deux sorties d'air (OUT1, OUT2),
- Un dispositif d'aiguillage (3) agencé à l'intérieur de ladite goulotte principale (21), entre la première sortie d'air (OUT1) et la deuxième sortie d'air (OUT2), ledit dispositif d'aiguillage comportant des volets mobiles (30, 31) commandables entre une première position dans laquelle l'entrée d'air communique uniquement avec la première sortie d'air et une deuxième position dans laquelle l'entrée d'air communique au moins avec la deuxième sortie d'air.

## Patentansprüche

1. Lüfterblock (5) für eine elektrische Umhüllung, umfassend einen Lüfter (VENT) und ein Gehäuse (6), das einen Sockel (60) und einen auf dem Sockel montierten Deckel (61) aufweist,
wobei das Gehäuse (6) die Form eines geraden Pflastersteins mit einer quadratischen Grundfläche, vier Seitenflächen und einer Oberseite aufweist,
wobei der Sockel (60) eine Bodenwand (600), die die Basis des Gehäuses bildet, und eine Seitenwand, die den vier Seitenflächen des Gehäuses folgt, eine Öffnung (62), die durch seine Bodenwand hindurch ausgebildet ist, und einen Sitz, der um seine Öffnung herum ausgebildet ist und den Lüfter aufnimmt, aufweist,
wobei der Deckel (61) auf dem Sockel (60) ruht ist und die Oberseite des Gehäuses aufweist,
und wobei die Seitenwand des Sockels entlang jeder Seitenfläche ein erstes Gitter (601) aufweist,
**dadurch gekennzeichnet, dass** der Lüfterblock (5) entlang jeder Seitenfläche ein zweites Gitter (501) aufweist, das schwenkbar montiert ist zwischen:
- einer geschlossenen Position, in der das zweite Gitter (501) das erste Gitter (601) der entsprechenden Seitenfläche abdeckt, indem es gegen dieses erste Gitter gefaltet wird, sodass der Lüfterblock (5) eine erste Konfiguration aufweist, die eine erste Schutzart (IP) des Lüfterblocks definiert, und
- einer oder mehreren offenen Positionen, in denen jeweils das zweite Gitter (501) in Bezug auf das erste Gitter (601) der entsprechenden Seitenfläche angehoben wird, indem es um einen bestimmten Neigungswinkel geschwenkt wird der ungleich Null ist, sodass der Lüfterblock (5) eine Konfiguration aufweist, die sich von der ersten Konfiguration unterscheidet und die eine Schutzart (IP) des Lüfterblocks definiert, die sich von der ersten Schutzart unterscheidet.

2. Lüfterblock nach Anspruch 1, **gekennzeichnet durch** dass er mehrere innere Aufnahmen des Gehäuses (6) aufweist, die jeweils vor jedem ersten Gitter des Sockels angeordnet sind, und dass der Lüfterblock ein separates Filterelement (65) aufweist, das in jeder Aufnahme vor jedem ersten Gitter des Sockels positioniert ist.

3. Lüfterblock nach Anspruch 2, **dadurch gekennzeichnet, dass** der Deckel mehrere schwenkbare Klappen (640) aufweist, die jeweils Zugang zu einer separaten Aufnahme geben, die das Filterelement (65) aufnimmt.

4. Lüfterblock nach einem der Ansprüche 1 bis 3, **dadurch gekennzeichnet, dass** jedes zweite Gitter (501) an dem Deckel (61) befestigt und schwenkbar an diesem Deckel montiert ist.

5. Lüfterblock nach einem der Ansprüche 1 bis 4, **dadurch gekennzeichnet, dass** er eine Schutzhaube (67) aufweist, die eine Kappe bildet, die dazu bestimmt ist, das Gehäuse (6) abzudecken.

6. Lüfterblock nach Anspruch 5, **dadurch gekennzeichnet, dass** die Schutzhaube (67) eine an den Deckel angesetzte Hauptwand und mehrere schräge Seitenflanken aufweist, die sich vor den Seitenflächen des Gehäuses (6) erstrecken.

7. Lüfterblock nach einem der Ansprüche 1 bis 6, **dadurch gekennzeichnet, dass** in der oder jeder offenen Position der Neigungswinkel kleiner ist als 90°.

8. Elektrische Anlage, umfassend eine elektrische Umhüllung, die mit einer unteren Wand (10), einer oberen Wand (11) und Seitenwänden (12) versehen ist, **dadurch gekennzeichnet, dass** sie ein modulares Lüftungssystem aufweist, umfassend mehrere Lüfterblöcke (5.1, 5.2, 5.3, 5.4), wobei jeder Lüfterblock wie definiert in einem der Ansprüche 1 bis 7 ist und an der oberen Wand (11) der elektrischen Umhüllung positioniert ist.

9. Elektrische Anlage nach Anspruch 8, **dadurch gekennzeichnet, dass** die Lüfterblöcke an der oberen Wand (11) des Schaltschranks positioniert sind, um an mindestens einer ihrer Seitenflächen, an denen sich die jeweiligen zweiten Gitter (501) der Lüfterblöcke jeweils in ihrer geschlossenen Stellung befinden, aneinander anzugrenzen.

10. Elektrische Anlage nach Anspruch 8 oder 9, **dadurch gekennzeichnet, dass** sie ein Luftstrom-Managementsystem umfasst, das an die elektrische Umhüllung angepasst werden kann, das Luftstrom-Managementsystem umfassend:
- ein Gehäuse (22), umfassend mindestens einen Lufteinlass (IN1, IN2), der dazu bestimmt ist, mit dem Innenvolumen (V1) des elektrischen Gehäuses in Verbindung gebracht zu werden, mindestens zwei Luftauslässe (OUT1, OUT2) und mindestens einen Hauptkanal (20), der angeordnet ist, um den Lufteinlass (IN) mit den zwei Luftauslässen (OUT1, OUT2) zu verbinden,
- eine Abzweigungsvorrichtung (3), die innerhalb der Hauptrinne (21) zwischen dem ersten Luftauslass (OUT1) und dem zweiten Luftauslass (OUT2) angeordnet ist, wobei die Abzweigungsvorrichtung bewegliche Klappen (30, 31) umfasst, die zwischen einer ersten Position, in der der Lufteinlass nur mit dem ersten Luftauslass in Verbindung ist, und einer zweiten Position, in der der Lufteinlass zumindest mit dem zweiten Luftauslass in Verbindung ist, steuerbar sind.

## Claims

1. A ventilation unit (5) for an electrical enclosure, comprising a fan (VENT) and a housing (6) which comprises a base (60) and a cover (61) assembled on the base,
in which the housing (6) has the shape of a right block with a square base, four side faces and a top face,
in which said base (60) comprises a bottom wall (600) forming said base of the housing and a side wall following the four side faces of the housing, an opening (62) made through its bottom wall and a seat made around its opening and housing the fan,
in which the cover (61) is affixed to the base (60) and comprises the upper face of the housing,
and in which, along each side face, the side wall of the base comprises a first grid (601),
**characterised in that**, along each lateral face, the ventilation unit (5) comprises a second grid (501) mounted so as to pivot between:
- a closed position, in which the second grid (501) covers the first grid (601) of the corresponding lateral face, being folded against this first grid, so that the ventilation unit (5) has a first configuration defining a first protection index (IP) of the ventilation unit, and
- one or more open positions, in each of which the second grid (501) is raised with respect to the first grid (601) of the corresponding side face, being pivoted at a determined angle of inclination which is non-zero, so that the ventilation unit (5) has a configuration which is different from the first configuration and which defines a protection index (IP) of the ventilation unit, different from the first protection index.

2. A ventilation unit according to claim 1, **characterised in that** it comprises a plurality of internal housings of the housing (6), which are each arranged in front of each first grid of the base, and **in that** the ventilation unit comprises a separate filtration element (65) positioned in each housing, in front of each first grid of the base.

3. A ventilation unit according to claim 2, **characterised in that** the cover comprises a plurality of pivoting flaps (640), each giving access to a separate housing accommodating the filter element (65).

4. A ventilation unit according to one of claims 1 to 3, **characterised in that** each second grid (501) is fixed to the cover (61) and mounted so as to pivot on said cover.

5. A ventilation unit according to one of claims 1 to 4, **characterised in that** it comprises a protective cover (67) forming a cap intended to cover said housing (6).

6. A ventilation unit according to claim 5, **characterised in that** the protective cover (67) comprises a main wall affixed to the cover and a plurality of inclined lateral flanks extending in front of the lateral faces of the said housing (6).

7. A ventilation unit according to one of claims 1 to 6, **characterised in that**, in the or each open position, the angle of inclination is less than 90°.

8. An electrical installation comprising an electrical enclosure having a bottom wall (10), a top wall (11), and side walls (12), the installation being **characterised in that** it includes a modular ventilation system comprising a plurality of identical independent ventilation blocks (5.1, 5.2, 5.3, 5.4), each ventilation unit being as defined in one of claims 1 to 7 and positioned on the top wall (11) of the electrical enclosure.

9. An electrical installation according to claim 8, **characterised in that** the ventilation units are positioned on the top wall (11) of the electrical cabinet so as to be joined by at least one of their lateral faces at which the respective second grilles (501) of the ventilation units are each in their closed position.

10. An electrical installation according to claim 8 or 9, **characterised in that** it comprises an air flow management system which can be fitted to the electrical enclosure, the said air flow management system comprising:
- A housing (22) comprising at least one air inlet (IN1, IN2) intended to be placed in communication with the internal volume (V1) of the electrical enclosure, at least two air outlets (OUT1, OUT2) and at least one main duct (20) arranged to connect said air inlet (IN) to the two air outlets (OUT1, OUT2),
- A diverter device (3) arranged inside said main duct (21), between the first air outlet (OUT1) and the second air outlet (OUT2), said diverter device comprising movable flaps (30, 31) controllable between a first position in which the air inlet communicates only with the first air outlet and a second position in which the air inlet communicates at least with the second air outlet.
